# EUROPEAN PATENT APPLICATION

(11) **EP 2 426 817 A1**
(43) Date of publication of application: **07.03.2012**
(21) Application number: 11250486.5
(22) Date of filing: 20.04.2011
(51) Int. Cl.: H03F 1/42, H03F 1/48, H03F 3/21

(54) **Wide band power amplifier**

(30) Priority: 27.08.2010 JP 2010191284
(71) Applicant: Kabushiki Kaisha Toshiba, Minato-ku Tokyo 105-8001 (JP)
(72) Inventor: Ng, Choon Yong, Tokyo 105-8001 (JP)
(74) Representative: Granleese, Rhian Jane

(57) **Abstract**

According to one embodiment, a wide band power amplifier is provided, which includes: a first amplifier unit that has a first center frequency; a second amplifier unit that is arranged in parallel to the first amplifier unit, and has a second center frequency higher than the first center frequency; a power divider connected to an input of the first amplifier unit and an input of the second amplifier unit; and a first power combiner connected to an output of the first amplifier unit and an output of the second amplifier unit.

## Description

### CROSS REFERENCE TO RELATED APPLICATION

This application is based upon and claims the benefit of priority from prior Japanese Patent Applications No. P2010-191284 filed on August 27, 2010, the entire contents of which are incorporated herein by reference.

### FIELD

Embodiments described herein relate generally to a wide band power amplifier.

### BACKGROUND

There is a monolithic microwave integrated circuit (MMIC) as a technology for forming a circuit device by connecting a plurality of amplifier units in series to one another on one semiconductor substrate for the purpose of obtaining a high gain, each of the amplifier units being composed of a transistor, a matching circuit thereof, and a bias circuit.

Moreover, for the purpose of widening a band of an operation frequency, a two-stage amplifier is designed so that a center of small-signal gain frequency band characteristics of a first-stage amplifier unit can be shifted to a low frequency side, and that a center of small-signal gain frequency band characteristics of a second-stage amplifier unit can be shifted to a high frequency side, whereby small-signal gain frequency band characteristics of the two-stage amplifier concerned can be widened.

Among two-stage amplifiers, in the two-stage amplifier designed so that the center of the small-signal gain frequency band characteristics of the first-stage amplifier unit can be shifted to the low frequency side and that the center of the small-signal gain frequency band characteristics of the second-stage amplifier unit can be shifted to the high frequency side for the purpose of obtaining such a wide band, with regard to the small-signal gain, such frequency characteristics of the respective stages are superposed on each other, and the two-stage amplifier comes to have a wide band. However, in a large-signal gain near saturation, saturation characteristics of the second-stage amplifier unit become dominant, and accordingly, there is a problem that the two-stage amplifier does not have the wide band.

Moreover, in the first-stage amplifier unit and the second-stage amplifier unit, the respective frequency bands matched therewith are different from each other. Accordingly, if the first-stage amplifier unit and the second-stage amplifier unit are directly coupled to each other, then a large signal reflection occurs owing to impedance unmatching. This signal reflection can be suppressed by inserting an isolator between the first-stage amplifier unit and the second-stage amplifier unit; however, the isolator is formed of ferrite, and accordingly, has a problem that the isolator concerned cannot be applied to the MMIC in which all of the circuit constituent elements are formed on one semiconductor substrate.

### BRIEF DESCRIPTION OF THE DRAWINGS

FIG. 1 is a schematic circuit block configuration diagram of a wide band power amplifier according to a first embodiment.
FIG. 2 is a schematic circuit block configuration diagram of a wide band power amplifier according to a comparative example.
FIG. 3 is a schematic circuit block configuration diagram of a first amplifier cell of the wide band power amplifier according to the first embodiment.
FIG. 4 is a schematic circuit block configuration diagram of a second amplifier cell of the wide band power amplifier according to the first embodiment.
FIG. 5A is a schematic diagram of input/output characteristics of the first amplifier cell of the wide band power amplifier according to the first embodiment.
FIG. 5B is a schematic diagram of input/output characteristics of the second amplifier cell of the wide band power amplifier according to the first embodiment.
FIG. 6 is a schematic diagram of frequency characteristics of the first amplifier cell and second amplifier cell of the wide band power amplifier according to the first embodiment.
FIG. 7A is a schematic diagram of input/output characteristics of the first amplifier cell and first amplifier unit of the wide band power amplifier according to the first embodiment.
FIG. 7B is a schematic diagram of input/output characteristics of the second amplifier cell and second amplifier unit of the wide band power amplifier according to the first embodiment.
FIG. 8A is a schematic diagram of frequency characteristics of the first amplifier unit, the second amplifier unit and the wide band power amplifier when input power Pin is sufficiently small in the wide band power amplifier according to the first embodiment.
FIG. 8B is a schematic diagram of frequency characteristics of the first amplifier unit, the second amplifier unit and the wide band power amplifier when the input power Pin is large in the wide band power amplifier according to the first embodiment.
FIG. 8C is a diagram where the respective characteristic examples of FIG. 8A and FIG. 8B are drawn in a lump.
FIG. 9A is a schematic diagram of input/output characteristics of a first amplifier cell and first amplifier unit of the wide band power amplifier according to the comparative example.
FIG. 9B is a schematic diagram of input/output characteristics of a second amplifier cell and second amplifier unit of the wide band power amplifier according to the comparative example.
FIG. 10A is a schematic diagram of frequency characteristics of the first amplifier unit, the second amplifier unit and the wide band power amplifier when the input power Pin is sufficiently small in the wide band power amplifier according to the comparative example.
FIG. 10B is a schematic diagram of frequency characteristics of the first amplifier unit, the second amplifier unit and the wide band power amplifier when the input power Pin is large in the wide band power amplifier according to the comparative example.
FIG. 10C is a diagram where the respective characteristic examples of FIG. 10A and FIG. 10B are drawn in a lump.
FIG. 11 is a circuit configuration example of a Wilkinson-type power divider/combiner applied to the wide band power amplifier according to the first embodiment.
FIG. 12 is a circuit configuration example of a branch line coupler-type power divider/combiner applied to the wide band power amplifier according to the first embodiment.
FIG. 13 is a circuit configuration example of a rat-race coupler-type power divider/combiner applied to the wide band power amplifier according to the first embodiment.
FIG. 14 is a circuit configuration example of a Lange coupler-type power divider/combiner applied to the wide band power amplifier according to the first embodiment.
FIG. 15 is a schematic circuit block configuration diagram of a wide band power amplifier according to a second embodiment.
FIG. 16 is a schematic circuit block configuration diagram of a wide band power amplifier according to a third embodiment.
FIG. 17A is a block configuration diagram of an N-way power divider applied to a wide band power amplifier according to a fourth embodiment.
FIG. 17B is a block configuration diagram of an N-way power combiner applied to the wide band power amplifier according to the fourth embodiment.
FIG. 18 is a schematic circuit block configuration diagram of the wide band power amplifier according to the fourth embodiment.
FIG. 19 is a schematic cross-sectional structure diagram showing a configuration of a MIM capacitor applicable to a capacitor that composes each of matching circuits of the wide band power amplifiers according to the first to fourth embodiments.
FIG. 20 is a schematic planar pattern configuration diagram showing a configuration of an FET applicable to each of the wide band power amplifiers according to the first to fourth embodiments.
FIG. 21 is a schematic planar pattern configuration diagram showing another configuration of the FET applicable to each of the wide band power amplifiers according to the first to fourth embodiments.

### DETAILED DESCRIPTION

Next, a description is made of embodiments with reference to the drawings.

According to one embodiment, a wide band power amplifier includes: a first amplifier unit; a second amplifier unit; a power divider; and a power combiner.

The first amplifier unit has a first center frequency. The second amplifier unit is arranged in parallel to the first amplifier unit, and has a second center frequency higher than the first center frequency. The power divider is connected to an input of the first amplifier unit and an input of the second amplifier unit. The power combiner is connected to an output of the first amplifier unit and an output of the second amplifier unit.

### [FIRST EMBODIMENT]

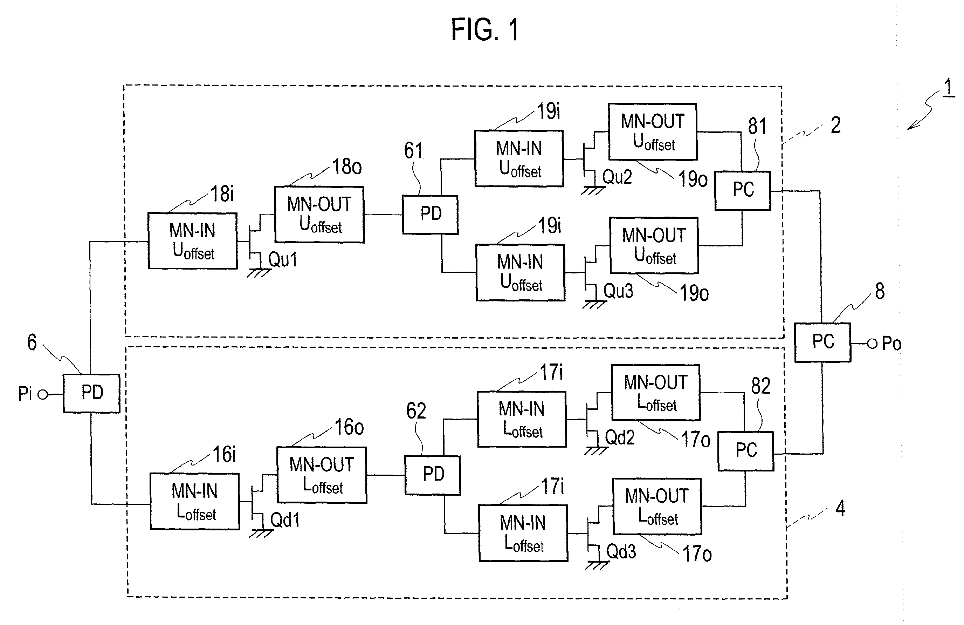

As shown in FIG. 1, a schematic circuit block configuration of a wide band power amplifier 1 according to a first embodiment includes: a first amplifier unit 4 that has a first center frequency; a second amplifier unit 2 that is arranged in parallel to the first amplifier unit 4, and has a second center frequency higher than the first center frequency; a power divider (PD) 6 connected to an input of the first amplifier unit 4 and an input of the second amplifier unit 2; and a power combiner (PC) 8 connected to an output of the first amplifier unit 4 and the second amplifier unit 2.

The first amplifier unit 4 includes: transistors Qd1, Qd2 and Qd3; a first input matching circuit (MN-IN L_{offset}) 16i connected to an input side of the transistor Qd1, and a first output matching circuit (MN-OUT L_{offset}) 16o connected to an output side of the transistor Qd1; a power divider (PD) 62 connected to the first output matching circuit (MN-OUT L_{offset}) 16o; a first input matching circuit (MN-IN L_{offset}) 17i connected to the power divider (PD) 62 and connected to an input side of the transistor Qd2, and a first output matching circuit (MN-OUT L_{offse}t) 17o connected to an output side of the transistor Qd2; a first input matching circuit (MN-IN L_{offset}) 17i connected to the power divider (PD) 62 and connected to an input side of the transistor Qd3, and a first output matching circuit (MN-OUT L_{offset}) 17o connected to an output side of the transistor Qd3; and a power combiner (PC) 82 that combines outputs of the two first output matching circuits (MN-OUT L_{offset}) 17o with each other.

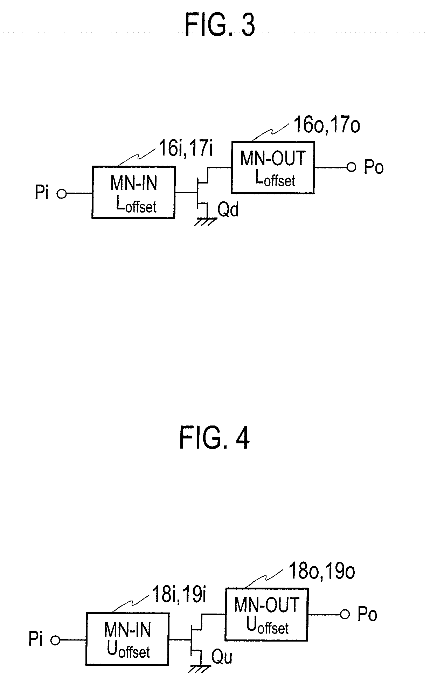

The transistors Qd1, Qd2 and Qd3 are generically denoted by reference symbol Qd. As shown in FIG. 3, a first amplifier cell is composed of: the transistor Qd; the first input matching circuits (MN-IN L_{offset}) 16i and 17i connected to the input side of the transistor Qd; and the first output matching circuits (MN-OUT L_{offset}) 16o and 17o connected to the output side of the transistor Qd.

The first input matching circuit (MN-IN L_{offset}) 16i converts an input impedance of the transistor Qd1 into 50 Ω at the first center frequency, and the first output matching circuit (MN-OUT L_{offset}) 16o converts an output impedance of the transistor Qd1 into 50 Ω at the first center frequency. In a similar way, the first input matching circuits (MN-IN L_{offset}) 17i individually convert input impedances of the transistors Qd2 and Qd3 into 50 Ω at the first center frequency, and the first output matching circuits (MN-OUT L_{offset}) 17o individually convert output impedances of the transistors Qd2 and Qd3 into 50 Ω at the first center frequency.

The second amplifier unit 2 includes: transistors Qu1, Qu2 and Qu3; a second input matching circuit (MN-IN H_{offset}) 18i connected to an input side of the transistor Qu1, and a second output matching circuit (MN-OUT H_{offset}) 18o connected to an output side of the transistor Qu1; a power divider (PD) 61 connected to the second output matching circuit (MN-OUT H_{offset}) 18o; a second input matching circuit (MN-IN H_{offset}) 19i connected to the power divider (PD) 61 and connected to an input side of the transistor Qu2, and a second output matching circuit (MN-OUT H_{offset}) 19o connected to an output side of the transistor Qu2; a second input matching circuit (MN-IN H_{offset}) 19i connected to the power divider (PD) 61 and connected to an input side of the transistor Qu3, and a second output matching circuit (MN-OUT H_{offset}) 19o connected to an output side of the transistor Qu3; and a power combiner (PC) 81 that combines outputs of the two second output matching circuits (MN-OUT H_{offset}) 19o with each other.

The transistors Qu1, Qu2 and Qu3 are generically denoted by reference symbol Qu. As shown in FIG. 4, a second amplifier cell is composed of: the transistor Qu; the first input matching circuits (MN-IN H_{offset}) 18i and 19i connected to the input side of the transistor Qd; and the first output matching circuits (MN-OUT H_{offset}) 18o and 19o connected to the output side of the transistor Qu.

The second input matching circuit (MN-IN H_{offset}) 18i converts an input impedance of the transistor Qu1 into 50 Ω at the second center frequency higher than the first center frequency, and the second output matching circuit (MN-OUT H_{offset}) 18o converts an output impedance of the transistor Qu1 at the second center frequency. In a similar way, the second input matching circuits (MN-IN H_{offset}) 19i convert input impedances of the transistors Qu2 and Qu3 into 50 Ω at the second center frequency, and the second output matching circuits (MN-OUT H_{offset}) 19o convert output impedances of the transistors Qu2 and Qu3 into 50 Ω at the second center frequency.

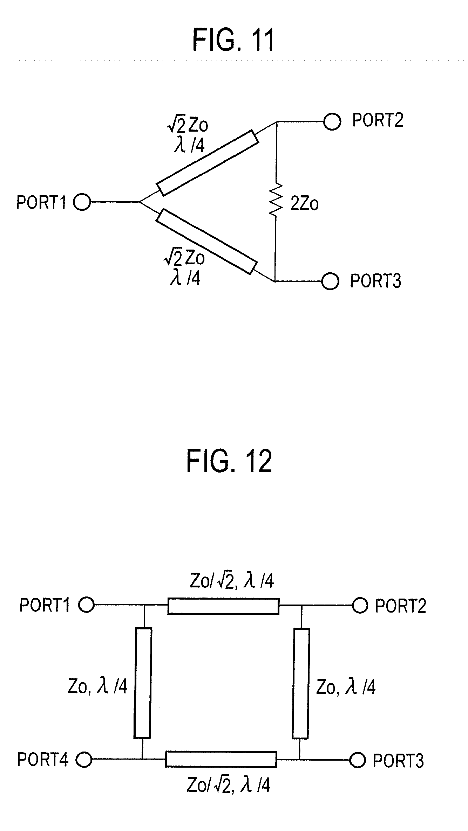

As described later with reference to FIG. 11 to FIG. 14, any of a Wilkinson-type power divider, a branch line coupler-type power divider, a rat-race coupler-type power divider, and a Lange coupler-type power divider can be applied to each of the power dividers (PD) 61 and 62.

As described later with reference to FIG. 11 to FIG. 14, any of the Wilkinson-type power divider, the branch line coupler-type power divider, the rat-race coupler-type power divider and the Lange coupler-type power divider can also be applied to each of the power combiners (PC) 81 and 82.

### (Comparative Example)

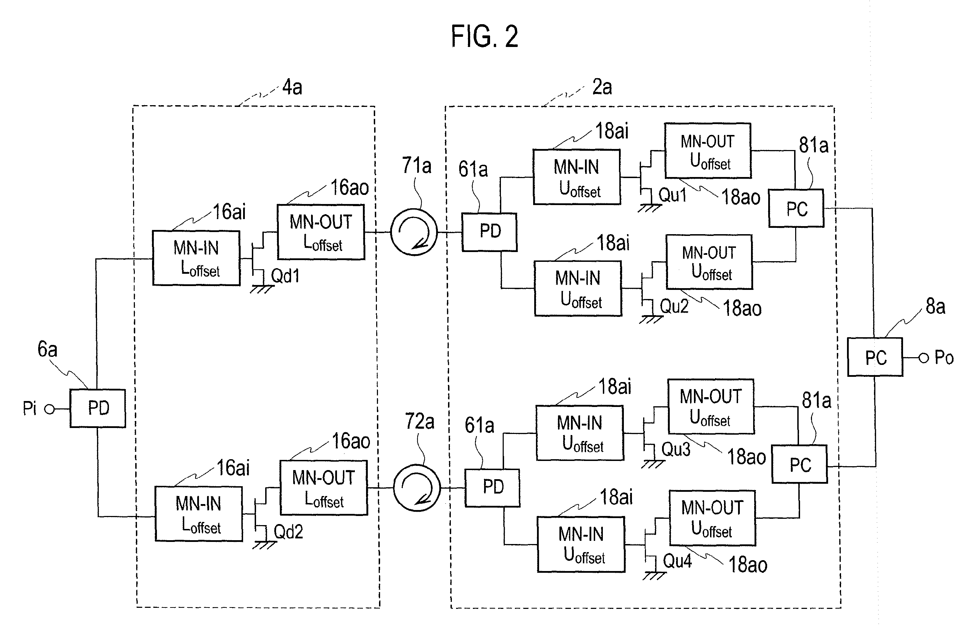

As shown in FIG. 2, a schematic circuit block configuration of a wide band power amplifier according to a comparative example includes: a first amplifier unit 4a that has a first center frequency; a second amplifier unit 2a that is arranged in series to the first amplifier unit 4a, and has a second center frequency higher than the first center frequency; isolators 71 a and 72a connected between outputs of the first amplifier unit 4a and inputs of the second amplifier unit 2a; a power divider (PD) 6a connected to inputs of the first amplifier unit 4a and; and a power combiner (PC) 8a connected to outputs of the second amplifier unit 2a.

The first amplifier unit 4a includes a parallel configuration of first amplifier cells, which is composed of: the transistors Qd1 and Qd2; first input matching circuits (MN-IN L_{offset}) 16ai and 16ai connected to the input sides thereof; and first output matching circuits (MN-OUT L_{offset}) 16ao and 16ao connected to the output sides thereof.

The first input matching circuits (MN-IN L_{offset}) 16ai and 16ai convert the input impedances of the transistors Qd1 and Qd2 into 50 Ω at the first center frequency. The first output matching circuits (MN-OUT L_{offset}) 16ao and 16ao convert the output impedances of the transistors Qd1 and Qd2 into 50 Ω at the first center frequency.

The second amplifier unit 2a includes: a parallel configuration of second amplifier cells, which is composed of transistors Qu1, Qu2, Qu3 and Qu4, second input matching circuits (MN-IN H_{offset}) 18ai, 18ai, 18ai and 18ai connected to respective input sides thereof, and second output matching circuits (MN-OUT H_{offset}) 18ao, 18ao, 18ao and 18ao connected to respective output sides thereof; power dividers (PD) 61a; and power combiners (PC) 81a. Here, the second input matching circuits (MN-IN H_{offset}) 18ai convert the input impedances of the transistors Qu1, Qu2, Qu3 and Qu4 at 50 Ω. The second output matching circuits (MN-OUT H_{offset}) 18ao convert the output impedances of the transistors Qu1, Qu2, Qu3 and Qu4 at 50 Ω.

The first output matching circuits (MN-OUT L_{offset}) 16ao and 16ao convert the output impedances of the transistors Qd1 and Qd2 into 50 Ω at the first center frequency; however, the second input matching circuits (MN-IN Hoffset) 18ai do not convert the input impedances of the transistors Qu1, Qu2, Qu3 and Qu4 at 50 Ω at the first center frequency, and accordingly, impedance unmatching occurs therebetween. For the purpose of suppressing a signal reflection owing to the impedance unmatching, the isolators 71 a and 72a are connected between the outputs of the first amplifier unit 4a and the inputs of the second amplifier unit 2a.

However, the isolators 71 a and 72a are formed of ferrite, and accordingly, cannot be applied to the MMIC in which all of the circuit constituent elements are formed on one semiconductor substrate.

### (Input/Output Characteristics and Frequency Characteristics)

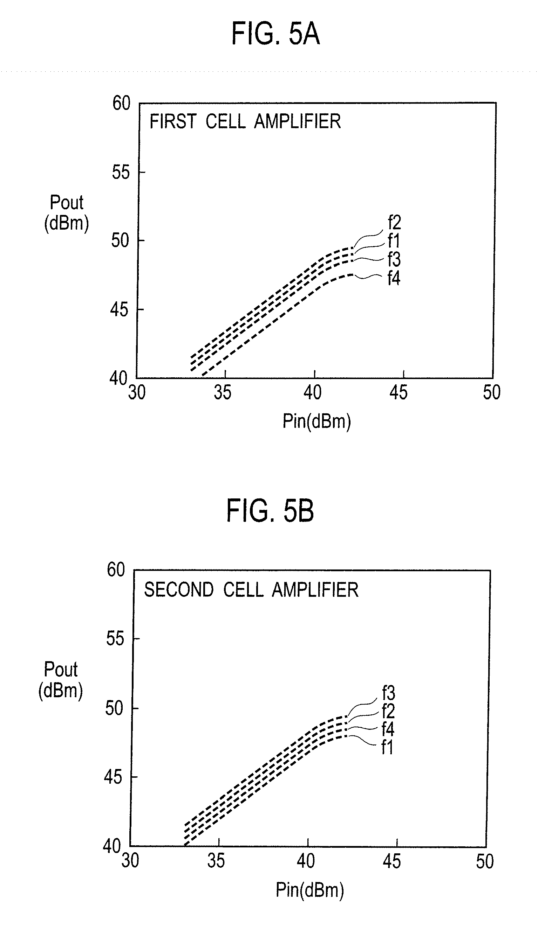

Input/output characteristics of the first amplifier cell (FIG. 3) of the wide band power amplifier according to the first embodiment are schematically represented as shown in FIG. 5A, and input/output characteristics of the second amplifier cell (FIG. 4) thereof are schematically represented as shown in FIG. 5B.

For example, as shown in FIG. 5A and FIG. 5B, the first amplifier cell and the second amplifier cell have characteristics where output power Pout is saturated when input power Pin is around 42 dBm. Moreover, as shown in FIG. 5A, in the first amplifier cell, the first input matching circuits (MN-IN L_{offset}) 16i and 17i and the first output matching circuits (MN-OUT L_{offset}) 16o and 17o are designed so that center frequencies thereof can be set at a frequency f2.

Moreover, as shown in FIG. 5B, in the second amplifier cell, the second input matching circuits (MN-IN H_{offset}) 18i and 19i and the second output matching circuits (MN-OUT H_{offset}) 18o and 19o are designed so that center frequencies thereof can be set at a frequency f3.

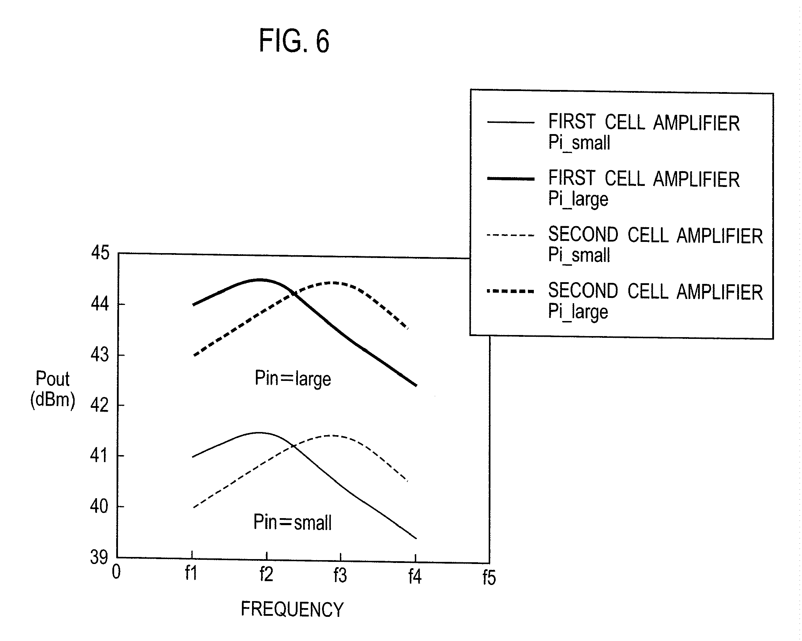

Frequency characteristics of the first amplifier cell (FIG. 3) and second amplifier cell (FIG. 4) of the wide band power amplifier according to the first embodiment are schematically represented as shown in FIG. 6.

In the first amplifier cell, the first input matching circuits (MN-IN L_{offset}) 16i and 17i and the first output matching circuits (MN-OUT L_{offset}) 16o and 17o are designed so that center frequencies thereof can be set at the frequency f2 both of when the input power Pin is small and when the input power Pin is large.

In the second amplifier cell, the second input matching circuits (MN-IN H_{offset}) 18i and 19i and the second output matching circuits (MN-OUT H_{offset}) 18o and 19o are designed so that center frequencies thereof can be set at the frequency f3 both of when the input power Pin is small and when the input power Pin is large.

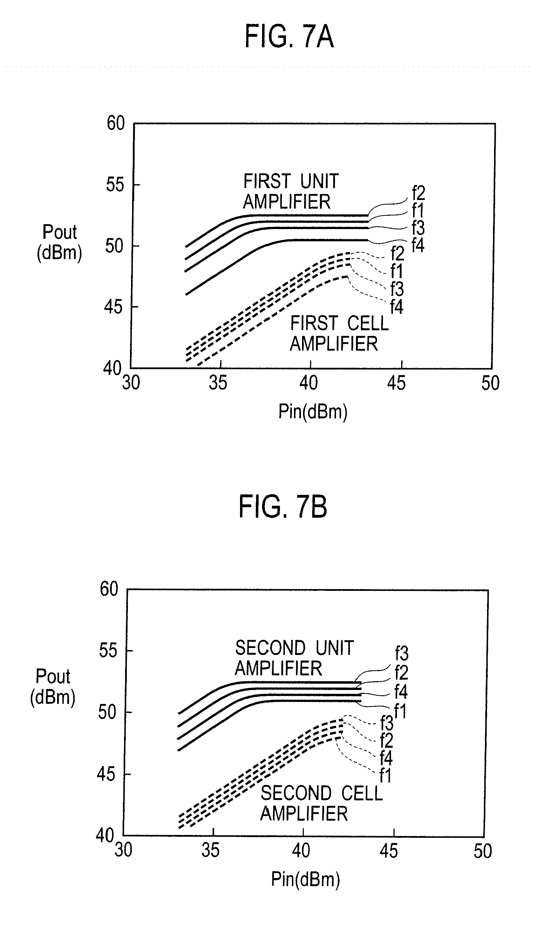

Input/output characteristics of the first amplifier cell (FIG. 3) and first amplifier unit 4 of the wide band power amplifier according to the first embodiment are schematically represented as shown in FIG. 7A, and input/output characteristics of the second amplifier cell (FIG. 4) and second amplifier unit 2 thereof are schematically represented as shown in FIG. 7B.

In the wide band power amplifier according to the first embodiment, the amplifier cells (FIG. 3, FIG. 4) different in gate width are connected in series to each other in the amplifier units (4, 2).

In the first amplifier cell (FIG. 3) in the first amplifier unit 4, as shown in FIG. 7A, the first input matching circuits (MN-IN L_{offset}) 16i and 17i and the first output matching circuits (MN-OUT L_{offse}t) 16o and 17o are designed so that a center frequency of each thereof can be set at the frequency f2.

In the second amplifier cell (FIG. 4) in the second amplifier unit 2, as shown in FIG. 7B, the second input matching circuits (MN-IN H_{offset}) 18i and 19i and the second output matching circuits (MN-OUT H_{offset}) 18o and 19o are designed so that a center frequency of each thereof can be set at the frequency f3.

As apparent from FIG. 7A and FIG. 7B, the output power Pout obtains saturation characteristics at 3 dBm or more where gains become double.

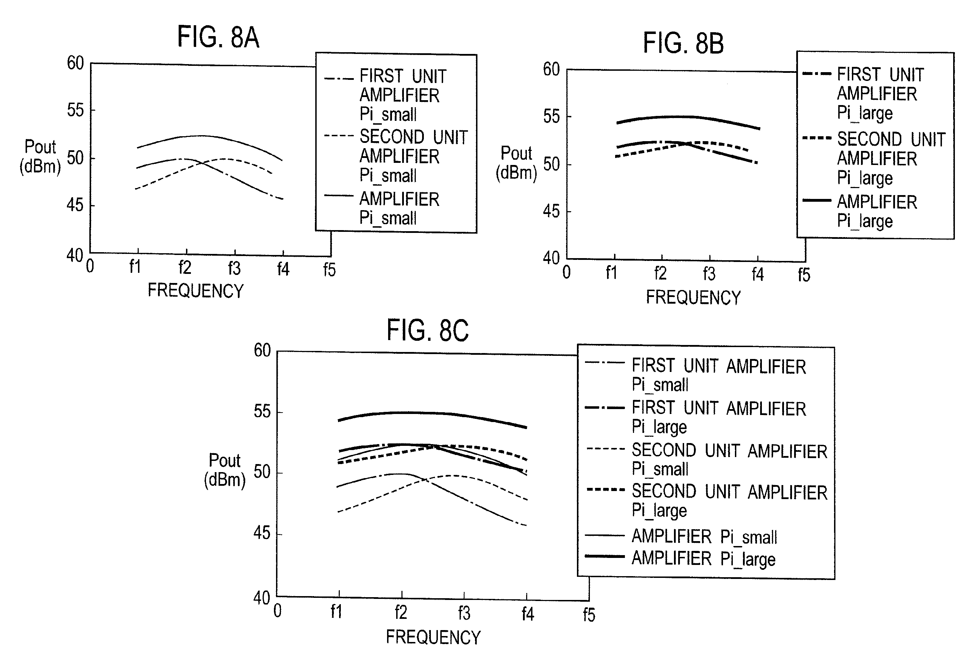

In the wide band power amplifier according to the first embodiment, frequency characteristics of the first amplifier unit 4, the second amplifier unit 2 and the wide band power amplifier 1 when the input power Pin is small are schematically represented as shown in FIG. 8A. Moreover, in the wide band power amplifier according to the first embodiment, frequency characteristics of the first amplifier unit 4, the second amplifier unit 2 and the wide band power amplifier 1 when the input power Pin is large are schematically represented as shown in FIG. 8B. Furthermore, a summary of the respective characteristic examples of FIG. 8 and FIG. 8B is represented as shown in FIG. 8C.

In the first amplifier unit 4, the first input matching circuits (MN-IN L_{offset}) 16i and 17i and the first output matching circuits (MN-OUT L_{offset}) 16o and 17o are designed so that a center frequency of each thereof can be set at the frequency f2 both of when the input power Pin is small and when the input power Pin is large.

In the second amplifier unit 2, the second input matching circuits (MN-IN H_{offset}) 18i and 19i and the second output matching circuits (MN-OUT H_{offset}) 18o and 19o are designed so that a center frequency of each thereof can be set at the frequency f3 both of when the input power Pin is small and when the input power Pin is large.

In the wide band power amplifier 1 according to the first embodiment, output power Pout (dBm) in which the output power of the first amplifier unit 4 and the output power of the second amplifier unit 2 are combined with each other is obtained, and accordingly, wide band output characteristics are exhibited both of when the input power Pin is small and when the input power Pin is large.

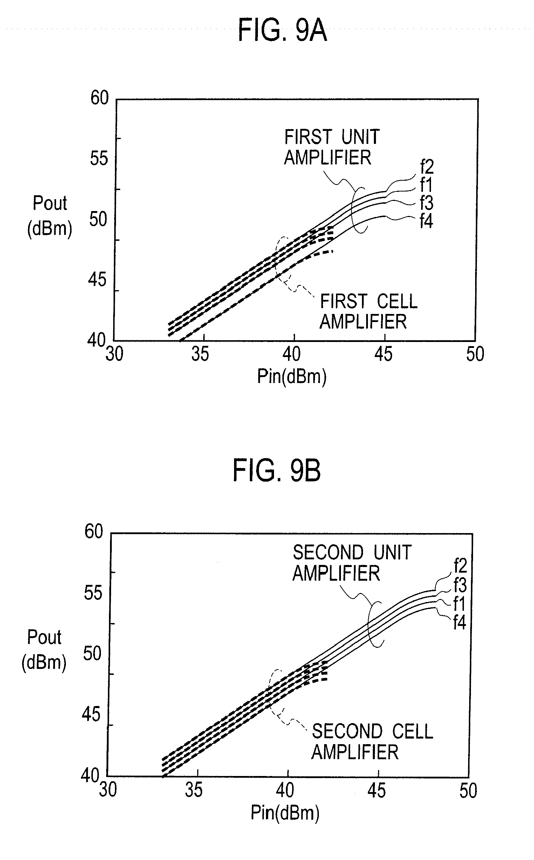

In the wide band power amplifier according to the comparative example, input/output power characteristics of the first amplifier cell and the first amplifier unit 4a are schematically represented as shown in FIG. 9A, and input/output power characteristics of the second amplifier cell and the second amplifier unit are schematically represented as shown in FIG. 9B.

In the comparative example, in the first amplifier unit 4a, for example, two first amplifier cells are connected in parallel to each other, and in the second amplifier unit 2a, for example, four second amplifier cells are connected in parallel to one another. In the first amplifier cells in the first amplifier unit 4a, the first input matching circuits (MN-IN L_{offset}) 16ai and the first output matching circuits (MN-OUT L_{offset}) 16ao are designed so that a center frequency of each thereof can be set at the frequency f2. Moreover, in the second amplifier cells in the second amplifier unit 2a, the second input matching circuits (MN-IN H_{offset}) 18ai and the second output matching circuits (MN-OUT H_{offset}) 18ao are designed so that a center frequency of each thereof can be set at the frequency f3.

As apparent from FIG. 9A, when the input power Pin is 3 dBm or more, saturation phenomena occur in the output power Pout. Gradients of the output power Pout/input power Pin are constant until such saturation characteristics are obtained, and accordingly, gains are not changed. Meanwhile, as apparent from FIG. 9B, when the input power Pin is 6 dBm or more, the saturation phenomena occur in the output power Pout. Also in this case, the gradients of the output power Pout/input power Pin are constant, and accordingly, the gains are not changed.

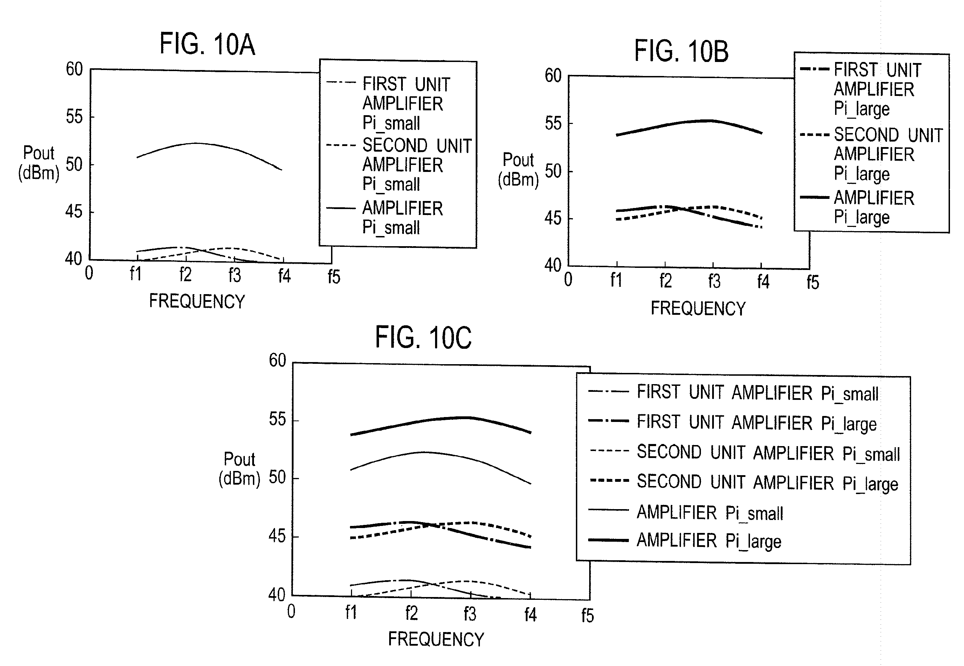

In the wide band power amplifier according to the comparative example, frequency characteristics of the first amplifier unit 4a, the second amplifier unit 2a and the wide band power amplifier when the input power Pin is sufficiently small are schematically represented as shown in FIG. 10A, and frequency characteristics of the first amplifier unit 4a, the second amplifier unit 2a and the wide band power amplifier when the input power Pin is large are schematically represented as shown in FIG. 10B. Moreover, a summary of the respective characteristic examples of FIG. 10A and FIG. 10B is represented as shown in FIG. 10C.

In the first amplifier unit 4a, the first input matching circuits (MN-IN L_{offset}) 16ai and the first output matching circuits (MN-OUT L_{offset}) 16ao are designed so that a center frequency of each thereof can be set at the frequency f2 both of when the input power Pin is small and when the input power Pin is large. In the second amplifier unit 2a, the second input matching circuits (MN-IN H_{offset}) 18ai and the second output matching circuits (MN-OUT H_{offset}) 18ao are designed so that a center frequency of each thereof can be set at the frequency f3 both of when the input power Pin is small and when the input power Pin is large.

In the wide band power amplifier according to the comparative example, in the first amplifier unit 4a and the second amplifier unit 2a, the input power Pin to the first amplifier unit 4a is sequentially amplified, and is then outputted therefrom. Accordingly, when the input power Pin is small, wide band output characteristics are exhibited; however, when the input power Pin is large, output saturation characteristics of the second amplifier unit 2a become dominant, and accordingly, the wide band output characteristics are not obtained.

### (Power Divider/Power Combiner)

### —Wilkinson-type power divider/power combiner

In the wide band power amplifier 1 according to the first embodiment, a circuit configuration example of the Wilkinson-type power divider/power combiner applicable to each of the power dividers (PD) 6, 61 and 62 and the power combiners (PC) 8, 81 and 82 is represented as shown in FIG. 11. Between a port 1 and ports 2 and 3, transmission lines with an impedance of √2Zo and a wavelength of λ/4 are formed, and between the port 2 and the port 3, a resistor with an impedance of 2Zo is connected. Here, Zo indicates a characteristic impedance of the transmission line, and λ indicates a wavelength corresponding to an operation frequency.

As the power divider (PD) 6, for example, the Wilkinson-type power divider/power combiner can be used by connecting the port 1 to an input terminal Pi, connecting the port 2 to the input of the first input matching circuit 16i, and connecting the port 3 to the input of the second input matching circuit 18i.

As the power divider (PD) 62, for example, the Wilkinson-type power divider/power combiner can be used by connecting the port 1 to the output of the first output matching circuit 16o_{,} and connecting the ports 2 and 3 to the inputs of the first input matching circuits 17i and 17i.

In a similar way, as the power divider (PD) 61, for example, the Wilkinson-type power divider/power combiner can be used by connecting the port 1 to the output of the second output matching circuit 18o, and connecting the ports 2 and 3 to the inputs of the second input matching circuits 19i and 19i.

As the power combiner (PC) 81, for example, the Wilkinson-type power divider/power combiner can be used by connecting the port 1 to the input of the power combiner (PC) 8, and connecting the ports 2 and 3 to the outputs of the second output matching circuits 19o and 19o_{.}

As the power combiner (PC) 82, for example, the Wilkinson-type power divider/power combiner can be used by connecting the port 1 to the input of the power combiner (PC) 8, and connecting the ports 2 and 3 to the outputs of the first output matching circuits 17o and 17o_{.}

As the power combiner (PC) 8, for example, the Wilkinson-type power divider/power combiner can be used by connecting the port 1 to an output terminal Po, and connecting the ports 2 and 3 to the outputs of the power combiners (PC) 81 and 82.

### —Branch line coupler-type power divider/power combiner—

In a similar way, in the wide band power amplifier 1 according to the first embodiment, a circuit configuration example of the branch line coupler-type power divider/power combiner applicable to each of the power dividers (PD) 6, 61 and 62 and the power combiners (PC) 8, 81 and 82 is represented as shown in FIG. 12. Between a port 1 and a port 2 and between a port 3 and a port 4, transmission lines with an impedance of Zo/√2 and a wavelength of λ/4 are formed, and between the port 1 and the port 4 and between the port 2 and the port 3, transmission lines with an impedance of Zo and a wavelength of λ/4 are formed.

As the power divider (PD) 6, for example, the branch line coupler-type power divider/power combiner can be used by connecting the port 1 to the input terminal Pi, connecting the port 2 to the input of the first input matching circuit 16i, and connecting the port 3 to the input of the second input matching circuit 18i.

As the power divider (PD) 62, for example, the branch line coupler-type power divider/power combiner can be used by connecting the port 1 to the output of the first output matching circuit 16o, and connecting the ports 2 and 3 to the inputs of the first input matching circuits 17i and 17i.

In a similar way, as the power divider (PD) 61, for example, the branch line coupler-type power divider/power combiner can be used by connecting the port 1 to the output of the second output matching circuit 18o_{,} and connecting the ports 2 and 3 to the inputs of the second input matching circuits 19i and 19i.

As the power combiner (PC) 81, for example, the branch line coupler-type power divider/power combiner can be used by connecting the port 2 to the input of the power combiner (PC) 8, and connecting the ports 1 and 4 to the outputs of the second output matching circuits 19o and 19o.

As the power combiner (PC) 82, for example, the branch line coupler-type power divider/power combiner can be used by connecting the port 2 to the input of the power combiner (PC) 8, and connecting the ports 1 and 4 to the outputs of the first output matching circuits 17o and 17o_{.}

As the power combiner (PC) 8, for example, the branch line coupler-type power divider/power combiner can be used by connecting the port 2 to the output terminal Po, and connecting the ports 1 and 4 to the outputs of the power combiners (PC) 81 and 82.

### —Rat-race coupler-type power divider/power combiner—

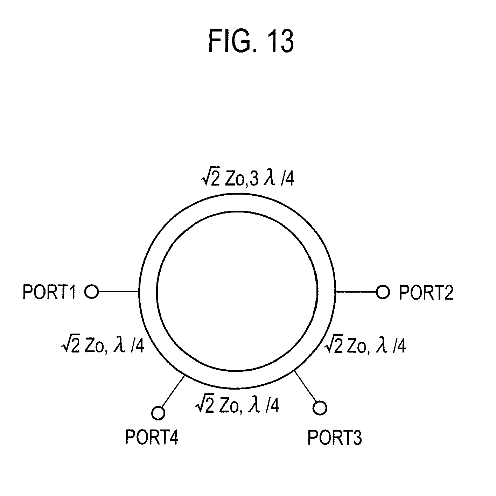

In a similar way, in the wide band power amplifier 1 according to the first embodiment, a circuit configuration example of the rat-race coupler-type power divider/power combiner applicable to each of the power dividers (PD) 6, 61 and 62 and the power combiners (PC) 8, 81 and 82 is represented as shown in FIG. 13. Between a port 1 and a port 2, a transmission line with an impedance of √2Zo and a wavelength of 3λ/4 is formed, and between the port 2 and a port 3, between the port 3 and a port 4, and between the port 4 and the port 1, transmission lines with an impedance of √2Zo and a wavelength of λ/4 are formed.

As the power divider (PD) 6, for example, the rat-race coupler-type power divider/power combiner can be used by connecting the port 1 to the input terminal Pi, connecting the port 2 to the input of the first input matching circuit 16i, and connecting the port 3 to the input of the second input matching circuit 18i.

As the power divider (PD) 62, for example, the rat-race coupler-type power divider/power combiner can be used by connecting the port 1 to the output of the first output matching circuit 16o_{,} and connecting the ports 2 and 3 to the inputs of the first input matching circuits 17i and 17i.

In a similar way, as the power divider (PD) 61, for example, the rat-race coupler-type power divider/power combiner can be used by connecting the port 1 to the output of the second output matching circuit 18o_{,} and connecting the ports 2 and 3 to the inputs of the second input matching circuits 19i and 19i.

As the power combiner (PC) 81, for example, the rat-race coupler-type power divider/power combiner can be used by connecting the port 2 to the input of the power combiner (PC) 8, and connecting the ports 1 and 4 to the outputs of the second output matching circuits 19o and 19o.

As the power combiner (PC) 82, for example, the rat-race coupler-type power divider/power combiner can be used by connecting the port 2 to the input of the power combiner (PC) 8, and connecting the ports 1 and 4 to the outputs of the first output matching circuits 17o and 17o_{.}

As the power combiner (PC) 8, for example, the rat-race coupler-type power divider/power combiner can be used by connecting the port 2 to the output terminal Po, and connecting the ports 1 and 4 to the outputs of the power combiners (PC) 81 and 82.

### —Lange coupler-type power divider/power combiner—

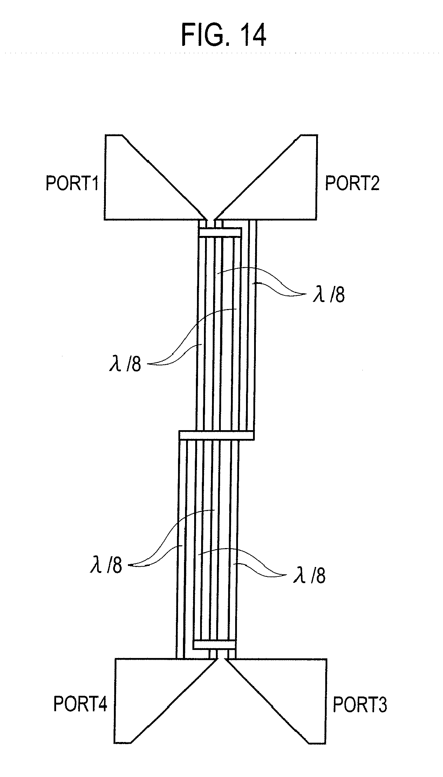

In a similar way, in the wide band power amplifier 1 according to the first embodiment, a circuit configuration example of the Lange coupler-type power divider/power combiner applicable to each of the power dividers (PD) 6, 61 and 62 and the power combiners (PC) 8, 81 and 82 includes, for example, a configuration in which a plurality of λ/8 transmission lines are connected to one another by bridges as shown in FIG. 14.

As the power divider (PD) 6, for example, the Lange coupler-type power divider/power combiner can be used by connecting the port 1 to the input terminal Pi, connecting the port 2 to the input of the first input matching circuit 16i, and connecting the port 3 to the input of the second input matching circuit 18i.

As the power divider (PD) 62, for example, the Lange coupler-type power divider/power combiner can be used by connecting the port 1 to the output of the first output matching circuit 16o, and connecting the ports 2 and 3 to the inputs of the first input matching circuits 17i and 17i.

In a similar way, as the power divider (PD) 61, for example, the Lange coupler-type power divider/power combiner can be used by connecting the port 1 to the output of the second output matching circuit 18o_{,} and connecting the ports 2 and 3 to the inputs of the second input matching circuits 19i and 19i.

As the power combiner (PC) 81, for example, the Lange coupler-type power divider/power combiner can be used by connecting the port 2 to the input of the power combiner (PC) 8, and connecting the ports 1 and 4 to the outputs of the second output matching circuits 19o and 19o.

As the power combiner (PC) 82, for example, the Lange coupler-type power divider/power combiner can be used by connecting the port 2 to the input of the power combiner (PC) 8, and connecting the ports 1 and 4 to the outputs of the first output matching circuits 17o and 17o.

As the power combiner (PC) 8, for example, the Lange coupler-type power divider/power combiner can be used by connecting the port 2 to the output terminal Po, and connecting the ports 1 and 4 to the outputs of the power combiners (PC) 81 and 82.

In accordance with the wide band power amplifier according to the first embodiment, for example, the frequency is divided into the low band and the high band, and the high-band amplifier and the low-band amplifier are connected in parallel to each other through the power divider and the power combiner. In such a way, the band of the operation frequency can be widened, and good flatness of the output characteristics can also be achieved.

In accordance with the wide band power amplifier according to the first embodiment, the isolators become unnecessary, and accordingly, it is possible to form the MMIC as one chip.

### [SECOND EMBODIMENT]

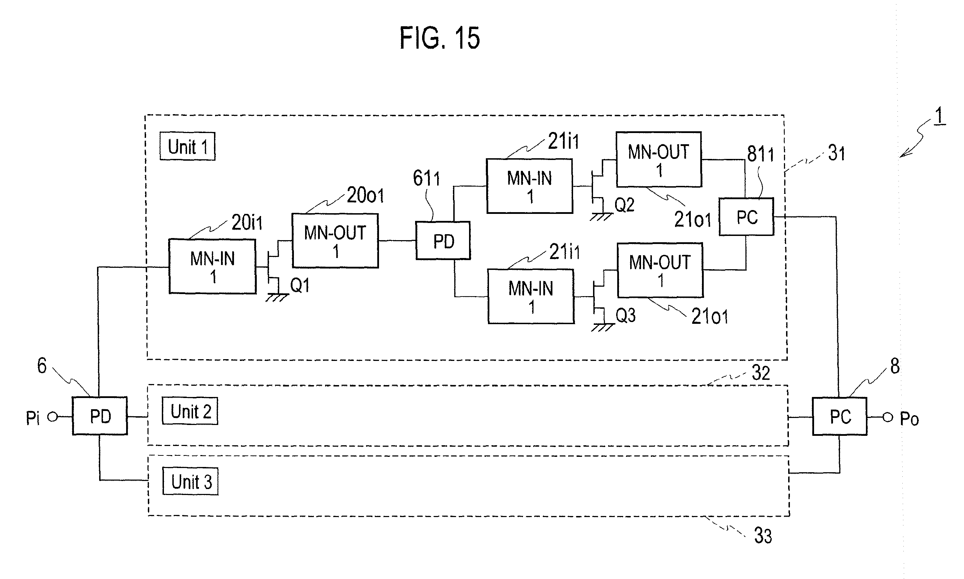

As shown in FIG. 15, a wide band power amplifier 1 according to a second embodiment includes: a first amplifier unit 3₁ that has a first center frequency; a second amplifier unit 3₂ that is arranged in parallel to the first amplifier unit 3₁, and has a second center frequency higher than the first center frequency; a third amplifier unit 3₃ that is arranged in parallel to the first amplifier unit 3₁ and the second amplifier unit 3₂, and has a third center frequency higher than the first center frequency and lower than the second center frequency; a power divider (PD) 6 connected to an input of the first amplifier unit 3₁, an input of the second amplifier unit 3₂, and an input of the third amplifier unit 3₃; and a power combiner (PC) 8 connected to an output of the first amplifier unit 3₁, an output of the second amplifier unit 3₂, and an output of the third amplifier unit 3₃. Here, the first center frequency is equal to a frequency for obtaining the maximum power amplification between the input and the output in the first amplifier unit 3₁, the second center frequency is equal to a frequency for obtaining the maximum power amplification between the input and the output in the second amplifier unit 3₂, and the third center frequency is equal to a frequency for obtaining the maximum power amplification between the input and the output in the third amplifier unit 3₃.

The first amplifier unit 3₁ includes: transistors Q1, Q2 and Q3; a first input matching circuit (MN-IN 1) 20i1 connected to an input side of the transistor Q1, and a first output matching circuit (MN-OUT 1) 20o1 connected to an output side of the transistor Q1; a power divider (PD) 61₁ connected to the first output matching circuit (MN-IN 1) 20o1; a first input matching circuit (MN-IN 1) 21i1 connected to the power divider (PD) 61₁ and connected to an input side of the transistor Q2, and a first output matching circuit (MN-OUT 1) 21o1 connected to an output side of the transistor Q2; a first input matching circuit (MN-IN 1) 21i1 connected to the power divider (PD) 61₁ and connected to an input side of the transistor Q3, and a first output matching circuit (MN-OUT 1) 21o1 connected to an output side of the transistor Q3; and a power combiner (PC) 81₁ that combines outputs of the two first output matching circuits (MN-OUT 1) 21o1 with each other.

A first amplifier cell is composed of: the transistors Q1, Q2 and Q3; the first input matching circuits (MN-IN 1) 20i1 and 21i1 connected to the input sides of the transistors Q1, Q2 and Q3; and the first output matching circuits (MN-OUT 1) 20i1 and 21i1 connected to the output sides of the transistors Q1, Q2 and Q3.

The first input matching circuit (MN-IN 1) 20i1 converts an input impedance of the transistor Q1 into 50 Ω at the first center frequency, and the first output matching circuit (MN-OUT 1) 20o1 converts an output impedance of the transistor Q1 into 50 Ω at the first center frequency. In a similar way, the first input matching circuits (MN-IN 1) 21i1 individually convert input impedances of the transistors Q2 and Q3 into 50 Ω at the first center frequency, and the first output matching circuits (MN-OUT 1) 21o1 individually convert output impedances of the transistors Q2 and Q3 into 50 Ω at the first center frequency.

The second amplifier unit 3₂ includes: transistors Q1, Q2 and Q3; a second input matching circuit (MN-IN 2) 20i2 connected to an input side of the transistor Q1, and a second output matching circuit (MN-OUT 2) 20o2 connected to an output side of the transistor Q1; a power divider (PD) 61₂ connected to the second output matching circuit (MN-IN 2) 20o2; a second input matching circuit (MN-IN 2) 21i2 connected to the power divider (PD) 61₂ and connected to an input side of the transistor Q2, and a second output matching circuit (MN-OUT 2) 2102 connected to an output side of the transistor Q2; a second input matching circuit (MN-IN 2) 21i2 connected to the power divider (PD) 61₂ and connected to an input side of the transistor Q3, and a second output matching circuit (MN-OUT 2) 21o2 connected to an output side of the transistor Q3; and a power combiner (PC) 81₂ that combines outputs of the two second output matching circuits (MN-OUT 2) 21o2 with each other.

A second amplifier cell is composed of: the transistors Q1, Q2 and Q3; the second input matching circuits (MN-IN 2) 20i2 and 21i2 connected to the input sides of the transistors Q1, Q2 and Q3; and the second output matching circuits (MN-OUT 2) 20o2 and 21o2 connected to the output sides of the transistors Q1, Q2 and Q3.

The second input matching circuit (MN-IN 2) 20i2 converts an input impedance of the transistor Q1 into 50 Ω at the second center frequency, and the second output matching circuit (MN-OUT 2) 20o2 converts an output impedance of the transistor Q1 into 50 Ω at the second center frequency. In a similar way, the second input matching circuits (MN-IN 2) 21i2 individually convert input impedances of the transistors Q2 and Q3 into 50 Ω at the second center frequency, and the second output matching circuits (MN-OUT 2) 21o2 individually convert output impedances of the transistors Q2 and Q3 into 50 Ω at the second center frequency.

The third amplifier unit 3₃ is also composed in a similar way, and accordingly, a duplicate description is omitted.

In a similar way to the first embodiment, any of the Wilkinson-type power divider, the branch line coupler-type power divider, the rat-race coupler-type power divider and the Lange coupler-type power divider can be applied to each of the power dividers (PD) 6, 61₁ 61₂ and 61₃.

In a similar way to the first embodiment, any of the Wilkinson-type power divider, the branch line coupler-type power divider, the rat-race coupler-type power divider and the Lange coupler-type power divider can also be applied to each of the power combiners (PC) 8, 81₁, 81₂ and 81₃.

In accordance with the wide band power amplifier according to the second embodiment, for example, the frequency is divided into a low band, a middle band and a high band, and such low-band amplifier, middle-band amplifier and high-band amplifier are connected in parallel to one another through the power divider (PD) 6 and the power combiner (PC) 8. In such a way, the band of the operation frequency can be widened, and good flatness of the output characteristics can also be achieved.

In accordance with the wide band power amplifier according to the second embodiment, the isolators become unnecessary, and accordingly, it is possible to form the MMIC as one chip.

### [THIRD EMBODIMENT]

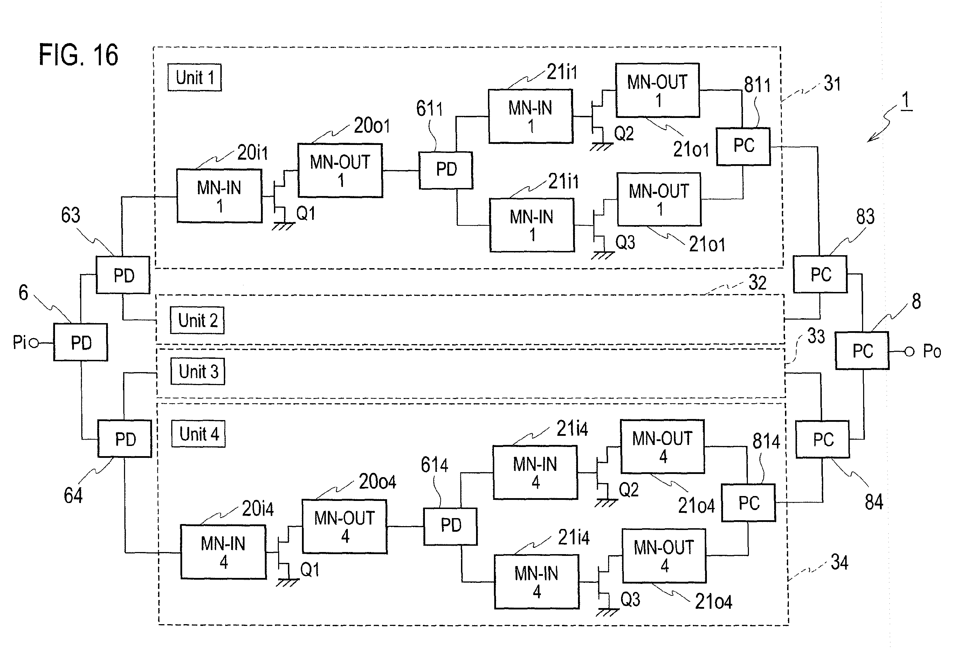

As shown in FIG. 16, a wide band power amplifier according to a third embodiment includes: a first amplifier unit 3₁ that has a first center frequency; a second amplifier unit 3₂ that is arranged in parallel to the first amplifier unit 3₁, and has a second center frequency higher than the first center frequency; a third amplifier unit 3₃ that is arranged in parallel to the second amplifier unit 3₂, and has a third center frequency higher than the second center frequency; a fourth amplifier unit 3₄ that is arranged in parallel to the third amplifier unit 3₃, and has a fourth center frequency higher than the third center frequency; a power divider (PD) 63 connected to an input of the first amplifier unit 3₁ and an input of the second amplifier unit 3₂; a power divider (PD) 64 connected to an input of the third amplifier unit 3₃ and an input of the fourth amplifier unit 3₄; a power combiner (PC) 83 connected to an output of the first amplifier unit 3₁ and an output of the second amplifier unit 3₂; and a power combiner (PC) 84 connected to an output of the third amplifier unit 3₃ and an output of the fourth amplifier unit 3₄.

The first amplifier unit 3₁ includes: transistors Q1, Q2 and Q3; a first input matching circuit (MN-IN 1) 201i connected to an input side of the transistor Q1, and a first output matching circuit (MN-OUT 1) 20o1 connected to an output side of the transistor Q1; a power divider (PD) 61₁ connected to the first output matching circuit (MN-IN 1) 20o1; a first input matching circuit (MN-IN 1) 21i1 connected to the power divider (PD) 61, and connected to an input side of the transistor Q2, and a first output matching circuit (MN-OUT 1) 21o1 connected to an output side of the transistor Q2; and a power combiner (PC) 81, that combines outputs of the two first output matching circuits (MN-OUT 1) 21o1 with each other.

A first amplifier cell is composed of: the transistors Q1, Q2 and Q3; the first input matching circuits (MN-IN 1) 20i1 and 21i1 connected to the input sides of the transistors Q1, Q2 and Q3; and the first output matching circuits (MN-OUT 1) 20o1 and 21o1 connected to the output sides of the transistors Q1, Q2 and Q3.

The first input matching circuit (MN-IN 1) 20i1 converts an input impedance of the transistor Q1 into 50 Ω at the first center frequency, and the first output matching circuit (MN-OUT 1) 20o1 converts an output impedance of the transistor Q1 into 50 Ω at the first center frequency. In a similar way, the first input matching circuits (MN-IN 1) 21i1 individually convert input impedances of the transistors Q2 and Q3 into 50 Ω at the first center frequency, and the first output matching circuits (MN-OUT 1) 21o1 individually convert output impedances of the transistors Q2 and Q3 into 50 Ω at the first center frequency.

The second amplifier unit 3₂ includes: transistors Q1, Q2 and Q3; a second input matching circuit (MN-IN 2) 20i2 connected to an input side of the transistor Q1, and a second output matching circuit (MN-OUT 2) 20o2 connected to an output side of the transistor Q1; a power divider (PD) 61₂ connected to the second output matching circuit (MN-OUT 2) 20o2; a second input matching circuit (MN-IN 2) 21i2 connected to the power divider (PD) 61₂ and connected to an input side of the transistor Q2, and a second output matching circuit (MN-OUT 2) 21o2 connected to an output side of the transistor Q2; and a power combiner (PC) 81₂ that combines outputs of the two second output matching circuits (MN-OUT 2) 21o2 with each other.

A second amplifier cell is composed of: the transistors Q1, Q2 and Q3; the second input matching circuits (MN-IN 2) 20i2 and 21i2 connected to the input sides of the transistors Q1, Q2 and Q3; and the second output matching circuits (MN-OUT 2) 20o2 and 21o2 connected to the output sides of the transistors Q1, Q2 and Q3.

The second input matching circuit (MN-IN 2) 20i1 converts an input impedance of the transistor Q1 into 50 Ω at the second center frequency, and the second output matching circuit (MN-OUT 2) 20o2 converts an output impedance of the transistor Q1 into 50 Ω at the second center frequency. In a similar way, the second input matching circuits (MN-IN 2) 21i2 individually convert input impedances of the transistors Q2 and Q3 into 50 Ω at the second center frequency, and the second output matching circuits (MN-OUT 2) 21o2 individually convert output impedances of the transistors Q2 and Q3 into 50 Ω at the second center frequency.

The third amplifier unit 3₃ and the fourth amplifier unit 3₄ are also composed in a similar way, and accordingly, a duplicate description is omitted.

In a similar way to the first embodiment, any of the Wilkinson-type power divider, the branch line coupler-type power divider, the rat-race coupler-type power divider and the Lange coupler-type power divider can be applied to each of the power dividers (PD) 6, 63, 64 and 61₁ to 61₄.

In a similar way to the first embodiment, any of the Wilkinson-type power divider, the branch line coupler-type power divider, the rat-race coupler-type power divider and the Lange coupler-type power divider can also be applied to each of the power combiners (PC) 8, 83, 84 and 81₁ to 81₄.

Here, the first center frequency is equal to a frequency for obtaining the maximum power amplification between the input and the output in the first amplifier unit 3₁, the second center frequency is equal to a frequency for obtaining the maximum power amplification between the input and the output in the second amplifier unit 3₂, the third center frequency is equal to a frequency for obtaining the maximum power amplification between the input and the output in the third amplifier unit 3₃, and the fourth center frequency is equal to a frequency for obtaining the maximum power amplification between the input and the output in the fourth amplifier unit 3₄.

In accordance with the wide band power amplifier according to the third embodiment, for example, the frequency is divided into a four bands, and the band amplifiers individually corresponding thereto are connected in parallel to one another through the power dividers and the power combiners. In such a way, the band of the operation frequency can be widened, and good flatness of the output characteristics can also be achieved.

In accordance with the wide band power amplifier according to the third embodiment, the isolators become unnecessary, and accordingly, it is possible to form the MMIC as one chip.

### [FOURTH EMBODIMENT]

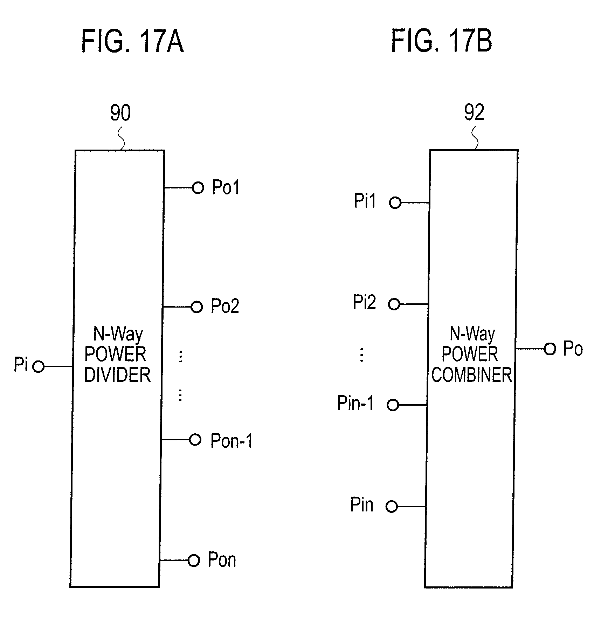

A block configuration of an N-way power divider 90 applied to a wide band power amplifier 1 according to a fourth embodiment is represented as shown in FIG. 17A, and a block configuration of an N-way power divider 92 applied thereto is represented as shown in FIG. 17B_{:}

For example, when an input side of the N-way power divider 90 is connected to the input terminal Pi, an output side of the N-way power divider 90 can obtain n pieces of outputs from output terminals Po1, Po2... and Pon. Specifically, the N-way power divider 90 can divide the power into N ways. On the contrary, for example, when an input side of the N-way power combiner 92 is connected to n pieces of input terminals Pi1, Pi2... and Pin, an output side of the N-way power combiner 92 can obtain one output from the n pieces of input terminals Pi1, Pi2... and Pin. Specifically, the N-way power combiner 92 can combine the power from the N ways with one another.

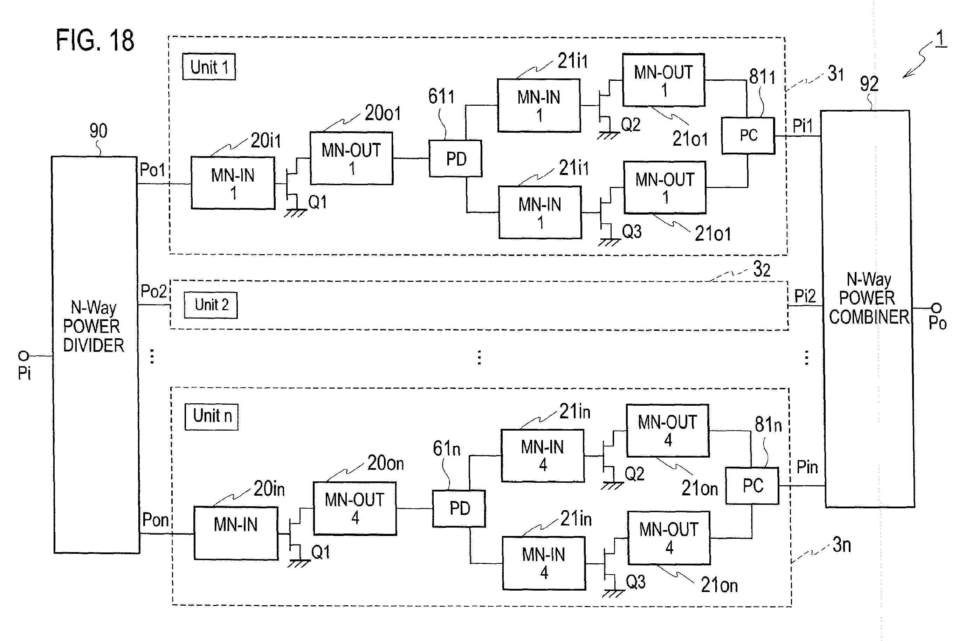

As sown in FIG. 18, a schematic circuit block configuration of the wide band power amplifier 1 according to the fourth embodiment includes: a plurality of amplifier units 3₁, 3₂, 3₃... and 3ₙ; the N-way power divider 90 connected to inputs of the plurality of amplifier units 3₁, 3₂, 3₃... and 3ₙ; and the N-way power combiner 92 connected to outputs of the plurality of amplifier units 3₁, 3₂, 3₃... and 3ₙ. The plurality of amplifier units 3₁, 3₂, 3₃... and 3ₙ have first, second, third... and n-th center frequencies, respectively. Here, as a magnitude relationship among the respective frequencies, the following is established:
first center frequency < second center frequency < third center frequency... < n-th center frequency

Here, each of the first, second, third... n-th center frequencies is equal to a frequency for obtaining the maximum power amplification between the input and the output in each of the amplifier units 3₁, 3₂, 3₃ ... 3ₙ.

In accordance with the wide band power amplifier according to the fourth embodiment, the plurality of amplifier units are connected in parallel to one another through the N-way power divider and the N-way power combiner. In such a way, the band of the operation frequency can be widened by means of a simple configuration, and good flatness of the output characteristics can be achieved.

Moreover, in accordance with the wide band power amplifier according to the fourth embodiment, the isolators become unnecessary, and accordingly, it is possible to form the MMIC as one chip.

### (MIM Capacitor)

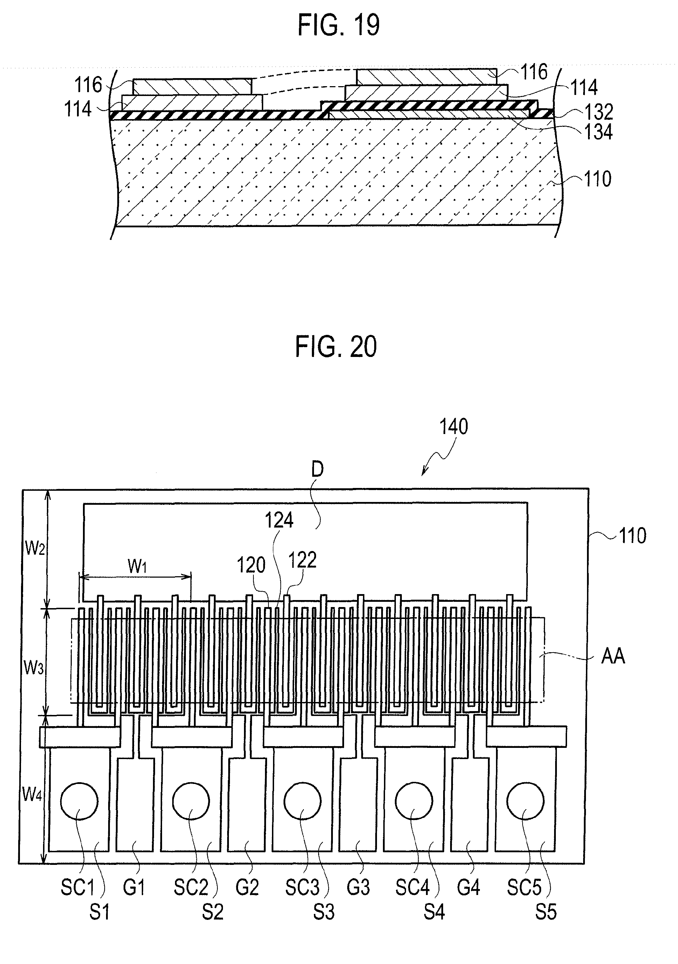

In the wide band power amplifiers 1 according to the first to fourth embodiments, as a capacitor that composes each of the matching circuits, there can be applied: an inter digital-type capacitor in which electrodes are arranged into a comb teeth-like inter digital structure; a metal/insulator/metal (MIM) capacitor in which electrodes are arranged into a stack structure while interposing an insulating layer therebetween; or the like. For example, as shown in FIG. 19, a configuration of such a MIM capacitor includes: a substrate 110; a metal pattern 134 arranged on the substrate 110; an insulating layer 132 arranged on the substrate 110 and the metal pattern 134; a metal contact layer 114 arranged on the insulating layer 132; and a metal layer 116 arranged on the metal contact layer 114. A MIM capacitance structure is formed of the metal pattern 134, the insulating layer 132, the metal contact layer 114 and the metal layer 116.

Note that, in the wide band power amplifiers 1 according to the first to fourth embodiments, an electrode wire or the like can be applied to an inductor that composes each of the matching circuits.

### (Semiconductor Device)

As shown in FIG. 20, a schematic planar pattern configuration of an FET 140 applicable to each of the wide band power amplifiers 1 according to the first to fourth embodiments includes: the substrate 110; a gate finger electrode 124, a source finger electrode 120 and a drain finger electrode 122, which are arranged on a first surface of the substrate 110, and individually have a plurality of fingers; a plurality of gate terminal electrodes G1, G2, G3 and G4, a plurality of source terminal electrodes S1, S2, S3, S4 and S5, and a drain terminal electrode D, which are arranged on the first surface of the substrate 110, and are formed by bundling the plurality of fingers individually for the gate finger electrode 124, the source finger electrode 120 and the drain finger electrode 122; VIA holes SC1, SC2, SC3, SC4 and SC5 arranged in lower portions of the source terminal electrodes S1, S2, S3, S4 and S5; and grounding electrodes (not shown) arranged on a second surface of the substrate 110 on an opposite side with the first surface and connected to the source terminal electrodes S1, S2, S3, S4 and S5 through the VIA holes SC1, SC2, SC3, SC4 and SC5.

In the example of FIG. 20, the gate terminal electrodes G1, G2, G3 and G4 and the source terminal electrodes S1, S2, S3, S4 and S5 are arranged on one end, and the drain terminal D is arranged on the other end.

In the vicinity of the surface of the substrate 110, an active area AA is formed on the substrate 110 located under the gate finger electrode 124, the source finger electrode 120 and the drain finger electrode 122.

In the example of FIG. 20, in the source terminal electrodes S1, S2, S3, S4 and S5 in the vicinity of the active area AA, the VIA holes SC1, SC2, SC3, SC4 and SC5 are formed from such a back surface of the substrate 110, and on the back surface of the substrate 110, a grounding conductor is formed. Then, in the case of grounding such a circuit element formed on the substrate 110, the circuit element concerned and the grounding conductor formed on the back surface of the substrate 110 are electrically connected to each other through the VIA holes SC1, SC2, SC3, SC4 and SC5 which penetrate the substrate 110.

Note that the gate terminal electrodes G1, G2, G3 and G4 are connected to semiconductor chips on the peripheries thereof by bonding wires and the like, and moreover, the drain terminal electrode D is also connected to a semiconductor chip on the periphery thereof by a bonding wire and the like.

Moreover, the substrate 110 may include any of a SiC substrate, a GaAs substrate, a GaN substrate, a substrate in which a GaN epitaxial layer is formed on the SiC substrate, a substrate in which the GaN epitaxial layer is formed on a Si substrate, a substrate in which a hetero-junction epitaxial layer composed of GaN/AIGaN is formed on the SiC substrate, a substrate in which the GaN epitaxial layer is formed on a sapphire substrate, the sapphire substrate or a diamond substrate, and a semi-insulating substrate.

Note that, in the example of FIG. 20, dimensions of the respective portions are, for example, as follows. A cell width W1 is approximately 120 µm, a cell width W2 is approximately 80 µm, a cell length W3 is approximately 200 µm, and a cell length W4 is approximately 120 µm. Moreover, a gate width WG is approximately 4.8 mm as a whole, which is a product of: 200 µm x 6 fingers x 4 cells.

The cell length W3 in the longitudinal direction of the gate finger electrode 124, the source finger electrode 120 and the drain finger electrode 122 is set to be shorter as the operation frequency increases from a microwave through a millimeter wave to a sub-millimeter wave. For example, the cell length W3 is approximately 25 µm to 50 µm in a millimeter wave band.

Moreover, a width of the source finger electrode 120 is, for example, approximately 40 µm, a width of the source terminal electrodes S1, S2, S3, S4 and S5 is, for example, approximately 100 µm. Furthermore, a formed width of the VIA holes SC1, SC2, SC3, SC4 and SC5 is, for example, approximately 10 µm to 40 µm.

### (Another Configuration of FET)

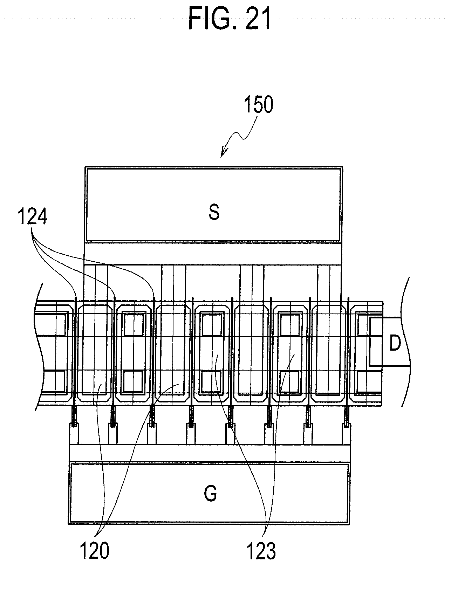

As shown in FIG. 21, a schematic planar pattern configuration of another FET 150 applicable to each of the wide band power amplifiers according to the first to fourth embodiments includes: a gate finger electrode 124, a source finger electrode 120 and a drain finger electrode 123, which are arranged on substrate, and individually have a plurality of fingers; a gate terminal electrode G and a source electrode S, which are arranged on the substrate, and are formed by bundling a plurality of fingers individually for the gate finger electrode 124 and the source finger electrode 120; and a drain terminal electrode D arranged on the substrate and formed by connecting the plurality of fingers of the drain finger electrode 123 to one another by overlay contact.

In accordance with the embodiment described above, the plurality of amplifier units are connected in parallel to one another through the power dividers and the power combiners. In such a way, the band of the operation frequency can be widened, and good flatness of the output characteristics can be achieved.

Note that a discrete transistor applied to the wide band power amplifiers according to the embodiments is not limited to the FET or a HEMT. As the discrete transistor, there can be applied: an amplifier element such as a laterally diffused metal-oxide-semiconductor field effect transistor (LDMOS) and a hetero-junction bipolar transistor (HBT); a micro electro mechanical systems (MEMS) element; and the like.

Moreover, the number of connection stages of such discrete transistors applied to the wide band power amplifiers according to the embodiments is not limited to two, and may be three or more.

While certain embodiments have been described, these embodiments have been presented by way of examples only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A wide band power amplifier comprising:
a first amplifier unit that has a first center frequency;
a second amplifier unit that is arranged in parallel to the first amplifier unit, and has a second center frequency higher than the first center frequency;
a first power divider connected to an input of the first amplifier unit and an input of the second amplifier unit; and
a first power combiner connected to an output of the first amplifier unit and an output of the second amplifier unit.

2. The wide band power amplifier according to claim 1, wherein
the first amplifier unit includes two second amplifier cells connected in parallel to each other, and one first amplifier cell connected in series to inputs of the second amplifier cells,
the first amplifier cell includes a first transistor, a first input matching circuit connected to an input side of the first transistor, and a first output matching circuit connected to an output side of the first transistor,
the second amplifier unit includes two fourth amplifier cells connected in parallel to each other, and one third amplifier cell connected in series to inputs of the fourth amplifier cells, and
the third amplifier cell includes a second transistor, a second input matching circuit connected to an input side of the second transistor, and a second output matching circuit connected to an output side of the second transistor,
wherein the first input matching circuit converts an input impedance of the first transistor at the first center frequency, the first output matching circuit converts an output impedance of the first transistor at the first center frequency, the second input matching circuit converts an input impedance of the second transistor at the second center frequency, and the second output matching circuit converts an output impedance of the second transistor at the second center frequency.

3. The wide band power amplifier according to claim 2, wherein
the first power divider is any of a Wilkinson-type power divider, a branch coupler-type power divider, a rat-race coupler-type power divider and a Lange coupler-type power divider, and the first power combiner is any of a Wilkinson-type power combiner, a branch coupler-type power combiner, a rat-race coupler-type power combiner and a Lange coupler-type power combiner.

4. The wide band power amplifier according to claim 1, further comprising:
a third amplifier unit that is arranged in parallel to the second amplifier unit, and has a third center frequency higher than the first center frequency and lower than the second center frequency,
wherein an input of the third amplifier unit is connected to the first power divider, and an output of the third amplifier unit is connected to the first power combiner.

5. The wide band power amplifier according to claim 4, wherein
the first amplifier unit includes two second amplifier cells connected in parallel to each other, and one first amplifier cell connected in series to inputs of the second amplifier cells,
the first amplifier cell includes a first transistor, a first input matching circuit connected to an input side of the first transistor, and a first output matching circuit connected to an output side of the first transistor,
the second amplifier unit includes two fourth amplifier cells connected in parallel to each other, and one third amplifier cell connected in series to inputs of the fourth amplifier cells,
the third amplifier cell includes a second transistor, a second input matching circuit connected to an input side of the second transistor, and a second output matching circuit connected to an output side of the second transistor,
the third amplifier unit includes two sixth amplifier cells connected in parallel to each other, and one fifth amplifier cell connected in series to inputs of the sixth amplifier cells, and
the fifth amplifier cell includes a third transistor, a third input matching circuit connected to an input side of the third transistor, and a third output matching circuit connected to an output side of the third transistor,
wherein the first input matching circuit converts an input impedance of the first transistor at the first center frequency, the first output matching circuit converts an output impedance of the first transistor at the first center frequency, the second input matching circuit converts an input impedance of the second transistor at the second center frequency, the second output matching circuit converts an output impedance of the second transistor at the second center frequency, the third input matching circuit converts an input impedance of the third transistor at the third center frequency, and the third output matching circuit converts an output impedance of the third transistor at the third center frequency.

6. The wide band power amplifier according to claim 4, wherein
the first power divider is any of a Wilkinson-type power divider, a branch coupler-type power divider, a rat-race coupler-type power divider and a Lange coupler-type power divider, and the first power combiner is any of a Wilkinson-type power combiner, a branch coupler-type power combiner, rat-race coupler-type power combiner and a Lange coupler-type power combiner.

7. The wide band power amplifier according to claim 1, further comprising:
a third amplifier unit that is arranged in parallel to the second amplifier unit, and has a third center frequency higher than the second center frequency;
a fourth amplifier unit that is arranged in parallel to the third amplifier unit, and has a fourth center frequency higher than the third center frequency;
a second power divider connected to an input of the third amplifier unit and an input of the fourth amplifier unit; and
a second power combiner connected to an output of the third amplifier unit and an output of the fourth amplifier unit.

8. The wide band power amplifier according to claim 7, further comprising:
a third power divider connected to an input of the first power divider and an input of the second power divider; and
a third power combiner connected to an output of the first power combiner and an output of the second power combiner.

9. The wide band power amplifier according to claim 7, wherein
the first amplifier unit includes two second amplifier cells connected in parallel to each other, and one first amplifier cell connected in series to inputs of the second amplifier cells,
the first amplifier cell includes a first transistor, a first input matching circuit connected to an input side of the first transistor, and a first output matching circuit connected to an output side of the first transistor,
the second amplifier unit includes two fourth amplifier cells connected in parallel to each other, and one third amplifier cell connected in series to inputs of the fourth amplifier cells,
the third amplifier cell includes a second transistor, a second input matching circuit connected to an input side of the second transistor, and a second output matching circuit connected to an output side of the second transistor,
the third amplifier unit includes two sixth amplifier cells connected in parallel to each other, and one fifth amplifier cell connected in series to inputs of the sixth amplifier cells,
the fifth amplifier cell includes a third transistor, a third input matching circuit connected to an input side of the third transistor, and a third output matching circuit connected to an output side of the third transistor,
the fourth amplifier unit includes two eighth amplifier cells connected in parallel to each other, and one seventh amplifier cell connected in series to inputs of the eighth amplifier cells, and
the seventh amplifier cell includes a fourth transistor, a fourth input matching circuit connected to an input side of the fourth transistor, and a fourth output matching circuit connected to an output side of the fourth transistor,
wherein the first input matching circuit converts an input impedance of the first transistor at the first center frequency, the first output matching circuit converts an output impedance of the first transistor at the first center frequency, the second input matching circuit converts an input impedance of the second transistor at the second center frequency, the second output matching circuit converts an output impedance of the second transistor at the second center frequency, the third input matching circuit converts an input impedance of the third transistor at the third center frequency, the third output matching circuit converts an output impedance of the third transistor at the third center frequency, the fourth input matching circuit converts an input impedance of the fourth transistor at the fourth center frequency, and the fourth output matching circuit converts an output impedance of the fourth transistor at the fourth center frequency.

10. The wide band power amplifier according to claim 8, wherein
each of the first power divider, the second power divider and the third power divider is any of a Wilkinson-type power divider, a branch coupler-type power divider, a rat-race coupler-type power divider and a Lange coupler-type power divider, and each of the the first power combiner, the second power combiner and the third power combiner is any of a Wilkinson-type power combiner, a branch coupler-type power combiner, rat-race coupler-type power combiner and a Lange coupler-type power combiner.

11. A wide band power amplifier comprising:
a plurality of amplifier units;
an N-way power divider connected to inputs of the plurality of amplifier units; and
an N-way power combiner connected to outputs of the plurality of amplifier units,
wherein the plurality of amplifier units have center frequencies different from one another.

12. The wide band power amplifier according to any one of claims 2, 5 and 9, wherein
the first transistor includes:
a substrate;
a gate finger electrode, a source finger electrode and a drain finger electrode, which are arranged on a first surface of the substrate, and individually have a plurality of fingers;
a plurality of gate terminal electrodes, a plurality of source terminal electrodes, and a drain terminal electrode, which are arranged on the first surface of the substrate, and are formed by bundling the plurality of fingers individually for the gate finger electrode, the source finger electrode and the drain finger electrode;
VIA holes arranged in lower portions of the source terminal electrodes; and
grounding electrodes arranged on a second surface of the substrate on an opposite side with the first surface and connected to the source terminal electrodes through the VIA holes.

13. The wide band power amplifier according to any one of claims 2, 5 and 9, wherein
the first transistor includes:
a substrate;
a gate finger electrode, a source finger electrode and a drain finger electrode, which are arranged on the substrate, and individually have a plurality of fingers;
a gate terminal electrode and a source terminal electrode, which are arranged on the substrate, and are formed by bundling the plurality of fingers individually for the gate finger electrode and the source finger electrode; and
a drain terminal electrode arranged on the substrate and formed by connecting the plurality of fingers of the drain finger electrode to one another by overlay contact.

14. The wide band power amplifier according to either one of claims 12 and 13, wherein
the substrate is any of a SiC substrate, a GaAs substrate, a GaN substrate, a substrate in which a GaN epitaxial layer is formed on the SiC substrate, a substrate in which the GaN epitaxial layer is formed on a Si substrate, a substrate in which a hetero-junction epitaxial layer composed of GaN/AIGaN is formed on the SiC substrate, a substrate in which the GaN epitaxial layer is formed on a sapphire substrate, the sapphire substrate or a diamond substrate, and a semi-insulating substrate.

15. The wide band power amplifier according to any one of claims 2, 5 and 9, wherein
the first input matching circuit and the first output matching circuit include MIM capacitors.
